# EUROPÄISCHE PATENTSCHRIFT

(11) **EP 2 245 739 B1**
(45) Veröffentlichungstag und Bekanntmachung des Hinweises auf die Patenterteilung: **06.07.2016**
(21) Anmeldenummer: 09704654.4
(22) Anmeldetag: 22.01.2009
(51) Int. Cl.: H03K 17/955

(54) **FEUCHTEUNABHÄNGIGER KAPAZITIVER EINKLEMMSCHUTZ**
MOISTURE-INDEPENDENT CAPACITIVE PINCH PROTECTION
SÉCURITÉ ANTI-PINCEMENT CAPACITIVE INSENSIBLE À L'HYGROMÉTRIE

(30) Priorität: 23.01.2008 DE 102008005783
(43) Veröffentlichungstag der Anmeldung: 03.11.2010
(73) Patentinhaber: Reime, Gerd, 77815 Bühl (DE)
(72) Erfinder: Reime, Gerd, 77815 Bühl (DE)
(74) Vertreter: Reinhardt, Harry
(86) Internationale Anmeldenummer: PCT/EP2009/000372
(87) Internationale Veröffentlichungsnummer: WO 2009/092577

(56) Entgegenhaltungen:
- EP-A2- 1 154 110
- US-A1- 2002 154 039
- US-A1- 2005 179 415

## Beschreibung

Die Erfindung betrifft ein Verfahren für einen Einklemmschutz nach dem Oberbegriff des Anspruches 1 sowie einen zugehörigen Einklemmschutz nach dem Oberbegriff des Anspruches 10.

### Stand der Technik

Im Industrie- und Automobilbereich werden Einklemmschutzsysteme wie z.B. gemäß der DE 196 32 592 C2 oder der dem Oberbegriff des Anspruches 1 zu Grunde liegende EP 1 154 110 A2 vielfach mit sogenannten Kontaktschienen oder Sicherheitsleisten realisiert. Diese sind in der Regel flexible Gummi- oder Kunststoffleisten, die zwei gegenüberliegende leitfähige Elemente aufweisen. Werden diese Leisten im Einklemmfall zusammengedrückt, treten die leitfähigen Elemente in Kontakt und dadurch wird z.B. der Antriebsmotor eines mechanisch bewegten Teiles reversiert. Eingesetzt werden diese taktilen Sicherheitsleisten z.B. an Dreh- oder Schiebetüren oder auch im Automobilbereich z. B. bei automatisch schließenden Fenstern oder Schiebedächern. Dabei soll ein im Schließbereich befindlicher Körperteil erkannt werden, damit er bei einem automatischen Schließvorgang nicht eingeklemmt wird. Im Fall der oben beschriebenen Sicherheitsleisten muss ein gewisser Druck durch den Körperteil auf diese Leiste ausgeübt werden, um einen Antriebsmotor zu stoppen oder zu reversieren.

Der in der EP 1 154 110 A2 gezeigte Einklemmschutz ist für die Scheibe eines Autofensters konzeptioniert und besteht aus dem Fensterrahmen, der als Masse fungiert, dem Dichtungsprofil, das als Grundkörper dient, und der Scheibe. Ins Dichtungsprofil ist, im eingebauten Zustand des Dichtungsprofils nach unten gerichtet, eine Sensorelektrode eingelassen, die sich entlang des Dichtungsprofils erstreckt. Zusätzlich kann eine Masseelektrode in das Dichtungsprofil eingelassen sein, die mit dem Fensterrahmen als Masse dient. Eine Regelung ist vorgesehen, die mit der Masseelektrode verbunden ist und selbst geerdet ist, was jedoch nicht unbedingt erforderlich ist, um einen Einklemmschutz zu bieten. Zudem muss, solange die Bezugsmasse der bekannten Kapazität in der Regelung und das Potential der Masseelektrode auf dem gleichen Level gehalten werden, die Masseelektrode nicht mit der Regelung verbunden sein. Auch könnte die Masseelektrode mit der Regelung, ohne geerdet zu sein, verbunden sein, um die Messregion durch das Laden der Masseelektrode auf ein vorgegebenes Potential in seiner geometrischen Form zu gestalten. Inwiefern die Masseelektrode weiter beschaltet werden kann, ist nicht offenbart und ergibt sich auch nicht aus der Funktion des gezeigten Einklemmschutzes.

Übliche Materialien für diese taktilen Sicherheitsleisten sind oft temperaturabhängig, das heißt, bei tiefen Temperaturen im Winter ist ein höherer Druck zum Schließen des Kontaktes erforderlich als bei höheren Temperaturen im Sommer. Daher ist der zum Reversieren benötigte Druck z.B. einer Autoscheibe oftmals für einen kleinen Kinderfinger zu groß, sodass eine akute Verletzungsgefahr besteht.

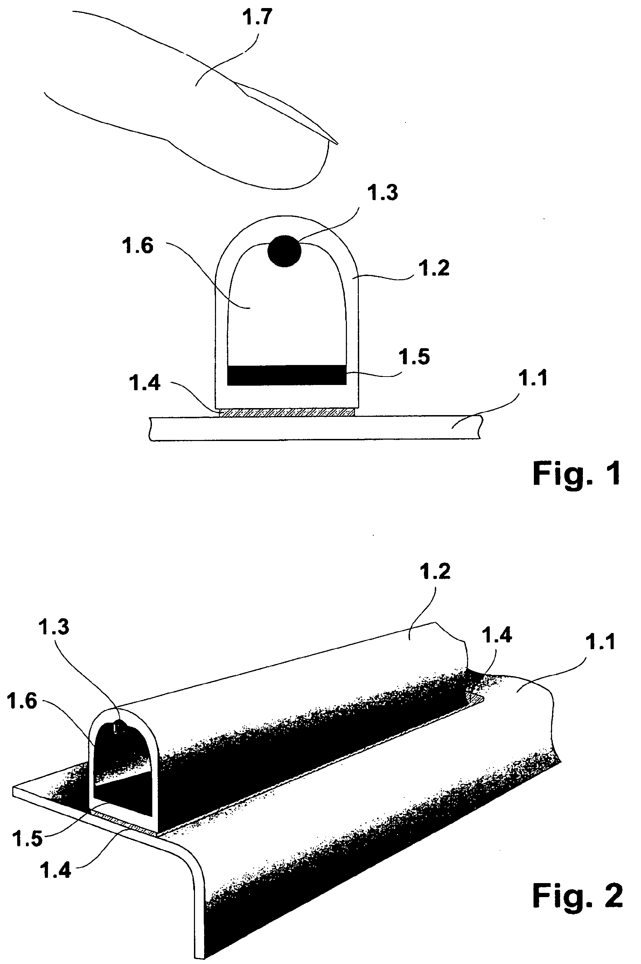

Eine Weiterentwicklung dieser Sicherheitsleisten ist ein sogenannter kapazitiver Einklemmschutz. Eine der oben beschriebenen Vorrichtung ähnliche Gummi- oder Kunststoffleiste wird mit entsprechenden Elektroden versehen, wie dies z.B. in Fig. 1 dargestellt ist. Diese reagieren auf die Kapazitätsänderung bei Annäherung eines Körperteils, z.B. eines Fingers. Der Grund für die Kapazitätsänderung ist der elektrisch leitfähige Wasseranteil im menschlichen Körper. Nachteilig ist, dass diese Systeme daher nicht nur auf die Annäherung z. B. einer Hand reagieren, sondern auch auf Spritzwasser oder Betauung bzw. auf Raureif.

Wesentlich in Erscheinung tritt bei bisherigen Systemen auch die Kapazität zwischen dem zweiten leitfähigen Element 1.3 und der Trägerfläche 1.1 aus Metall oder Kunststoff wie z.B. dem Fahrzeugchassis. Verschiedene Verfahren versuchen daher, die Kapazität zwischen dem zweiten leitfähigen Element 1.3 und der Trägerfläche 1.1 als Masse dadurch zu verringern, das sie das erste leitfähige Element 1.5 als sogenanntes "active ground" beschalten. Dazu wird das am zweiten leitfähigen Element 1.3 anliegende Signal hochohmig abgenommen und über einen Buffer niederohmig an das erste leitfähige Element 1.5 gelegt. Dies verringert zwar die Kapazität zwischen dem zweiten leitfähigen Element 1.3 und der Massefläche 1.1, hilft jedoch nicht wesentlich gegen den Einfluss von Feuchtigkeit.

Aus der US 2005/0179415 A1 sind ein Verfahren zum Schutz gegen ein Einklemmen von Gegenständen oder Körperteilen und ein Einklemmschutz in Form eines Kapazitätssensors bekannt. Der Einklemmschutz weist eine erste und eine zweite Sensorelektrode auf, wobei die erste Sensorelektrode gegenüber der Detektionsfläche des Kapazitätssensors und die zweite Sensorelektrode gegenüber der Detektionsfläche derart angeordnet sind, dass die Sensorelektroden voneinander getrennt und gegenüberliegend liegen. Eine Schutzelektrode (oder auch Abschirmelektrode) ist vorgesehen, die derart ausgestaltet ist, dass die erste und die zweite Sensorelektrode teilweise durch die Schutzelektrode bedeckt sind und auf der Seite der Detektionsfläche nicht von der Schutzelektrode bedeckt werden, die sich über die erste Sensorelektrode hinaus in Richtung der Detektionsfläche erstreckt. Das Potential der Schutzelektrode ist gleich dem Potential der ersten und zweiten Sensorelektroden, so dass die Kapazität zwischen der Schutzelektrode und der ersten und zweiten Sensorelektrode außer Acht gelassen werden kann. Da die Schutzelektrode sich über die erste Sensorelektrode hinaus in Richtung der Detektionsfläche erstreckt, kann der vorstehende Teil der Abschirmelektrode einen menschlichen Körper detektieren. Eine solche Abschirmung wird als "active guard" bezeichnet, da durch die Schutzelektrode die Sensorelektroden ihr eigenes Potential in Richtung der Schutzelektrode "sehen" kann, weshalb der diese Gegend umgebene Raum potentialfrei ist und de facto kein elektrisches Feld entsteht. Ohne die Schutzelektrode ist jedoch der Kapazitätssensor nicht funktionsfähig, so dass diese nicht einfach weggelassen werden kann.

Aus der CH 661 391 A5 ist ein kapazitiver Sensor bekannt, bei dem ein Signal von einer ersten Elektrode über eine kapazitive Kopplung an eine weitere, einem zu detektierenden Gegenstand näher als die erste Elektrode liegende weitere Elektrode übertragen wird, die das Signal aussendet und ihrerseits über eine kapazitive Kopplung an eine dritte Elektrode überträgt, die zum zu detektierenden Gegenstand in derselben Entfernung liegt wie die erste Elektrode und dieses Signal an die Auswerteschaltung weiterleitet.

Aus der EP 1 455 044 A2 ist ein Einklemmschutz mit zwei relativ zueinander beweglichen, leitfähigen Elementen bekannt, wobei neben den durch äußere Einflüsse ansprechenden kapazitiven Messsignalen auch eine zusätzliche Messgröße mittels Kontaktbildung enthalten ist.

### Aufgabe der Erfindung

Ausgehend von diesem Stand der Technik ist Aufgabe der vorliegenden Erfindung, einen kapazitiven Einklemmschutz zu schaffen, der nicht auf Spritzwasser, Betauung oder Raureif reagiert.

Diese Aufgabe wird durch ein Verfahren mit den Merkmalen des Anspruches 1 sowie durch einen Einklemmschutz mit den Merkmalen des Anspruches 10 gelöst.

Die Detektionsempfindlichkeit z.B. bei einer Handannäherung nimmt bei der beschriebenen Erfindung auch bei Anwesenheit von Wassertropfen auf der Oberfläche der Sicherheitsleiste nicht ab. Dadurch, dass sich beide leitfähigen Elemente in einer Leiste im Wesentlichen auf dem gleichen Potenzial befinden, wird auch das empfangende Element zum aussendenden Element und dasselbe gilt für äußerlich an der Leiste befindliche Wassertropfen. Durch die mögliche Erfassung kleinster Änderungen können dennoch äußere Einflüsse als Kapazitätsänderungen zuverlässig erfasst werden. Erreicht wird dies dadurch, dass das zweite leitfähige Element zur Vermittlung einer Kapazitätsänderung an die Sensorelektronik in Folge der äußeren Einflüsse mit dieser über einen hochohmigen Widerstand verbunden ist.

Vorteilhaft können die bisher eingesetzten taktilen Sicherheitsleisten verwendet werden, wobei dann eine Annäherung einer Hand kapazitiv in einer gewissen Entfernung zur Leiste, z.B. 50 mm, erfasst wird, während ein eingebrachter nichtleitender und nicht kapazitiv wirksamer Gegenstand wie bisher taktil, also durch mechanisches Zusammendrücken und dadurch erfolgende Berührung der leitfähigen Sektoren erkannt wird. Verzichtet man jedoch auf die taktile Sicherheit, kann die Sicherheitsleiste auch als kompaktes Element, d.h. ohne Hohlraum ausgeführt werden.

Weitere Vorteile ergeben sich aus den Unteransprüchen und der nachfolgenden Beschreibung bevorzugter Ausführungsbeispiele.

### Kurzbeschreibung der Figuren

In Folgenden wird die Erfindung an Hand von in den beigefügten Figuren dargestellten Ausführungsbeispielen näher erläutert. Es zeigen:
- Fig. 1, 2: eine taktile Sicherheitsleiste nach dem Stand der Technik in einer Schnittansicht und in perspektivischer Ansicht,
- Fig. 3: eine Anordnung bestehend aus zwei relativ zueinander beweglichen erfindungsgemäßen Sicherheitsleisten,
- Fig. 4: eine Anordnung gemäß Fig. 3, bei der eine Sicherheitsleiste durch ein dünnes leitfähiges flächiges Element ersetzt ist,
- Fig. 5: ein Blockschaltbild einer Schaltung zur Erfassung von kapazitiven Änderungen an der Sicherheitsleiste,
- Fig. 6: ein Blockschaltbild gemäß Fig. 5, in dem die Summationswiderstände durch Impedanzwandler ersetzt sind,
- Fig. 7: ein Blockschaltbild gemäß Fig. 5 mit einer Schaltung zur Überwachung der Sicherheitsleiste auf mechanische Beschädigungen,
- Fig. 8: ein Blockschaltbild gemäß Fig. 5 bei einer Lösung gemäß Fig. 4,
- Fig. 9: den Regelwert für das Ausführungsbeispiel der Fig. 5 ohne und bei einer Handannäherung,
- Fig. 10: eine erfindungsgemäße Sicherheitsleiste im Schnitt mit stark vereinfacht dargestellten Feldlinien,
- Fig. 11: eine Darstellung gemäß Fig. 10 mit Wassertropfen oder Feuchtigkeitsfilm auf der Oberfläche der Sicherheitsleiste.
- Fig. 12: eine Sicherheitsleiste im Schnitt nach dem Stand der Technik mit stark vereinfacht dargestellten Feldlinien des aussendenden Elementes,
- Fig. 13: eine Darstellung gemäß Fig. 12 mit Wassertropfen oder Feuchtigkeitsfilm auf der Oberfläche der Sicherheitsleiste,
- Fig. 14: ein Blockschaltbild gemäß Fig. 5, in dem der Anschluss der Sicherheitsleiste über Spannungsteiler erfolgt.

### Ausführliche Beschreibung bevorzugter Ausführungsbeispiele

Bevor die Erfindung im Detail beschrieben wird, ist darauf hinzuweisen, dass sie nicht auf die jeweiligen Bauteile der Vorrichtung sowie die jeweiligen Verfahrensschritte beschränkt ist, da diese Bauteile und Verfahren variieren können. Die hier verwendeten Begriffe sind lediglich dafür bestimmt, besondere Ausführungsformen zu beschreiben und werden nicht einschränkend verwendet. Wenn zudem in der Beschreibung oder in den Ansprüchen die Einzahl oder unbestimmte Artikel verwendet werden, bezieht sich dies auch auf die Mehrzahl dieser Elemente, solange nicht der Gesamtzusammenhang eindeutig etwas Anderes deutlich macht. Die Erfindung wird jetzt beispielhaft unter Bezug auf die beigefügten Zeichnungen näher erläutert. Allerdings handelt es sich bei den Ausführungsbeispielen nur um Beispiele, die nicht das erfinderische Konzept auf eine bestimmte Anordnung beschränken sollen.

Im Rahmen dieser Anmeldung werden die Begriffe "niederohmig" und "hochohmig" verwendet. Eine niederohmige Verbindung liegt vor, wenn der Einklemmschutz über einen Widerstand oder ein Widerstandsnetzwerk angeschlossen ist und die auftretende Kapazität des Einklemmschutz gegen Masse zum Beispiel 80 pF beträgt, so dass das Signal, welches hinter dem Widerstand oder Widerstandsnetzwerk ansteht, so verschliffen wird, dass sich keine Auswirkungen zeigen. Eine Handannäherung mit einer Änderung von z.B. 1 pF ruft dann keine Wirkung im Ausgangssignal hervor. Hochohmig bedeutet, dass ein Signal, das über diesen Widerstand oder dieses Widerstandsnetzwerk geschickt wird, eine Veränderung (zum Beispiel Verschleifen durch RC-Tiefpass) erfährt, die eindeutig erfasst werden kann und im Messsignal eine messbare Veränderung bewirkt. Im konkreten Fall liegt nach dieser Definition eine niederohmige Verbindung im Bereich von <200 Ohm vor, während eine hochohmige Verbindung bei einem Widerstand > 50 kOhm vorliegt. Zwischen diesen Werten sind von beiden beschriebenen Szenarien Einflüsse festzustellen.

Fig. 1, 2 zeigen eine taktile Sicherheitsleiste im Durchschnitt und in der perspektivischen Ansicht. Auf einer Trägerfläche 1.1 aus Metall oder Kunststoff, die z.B. das metallene Chassis eines Automobils sein kann, befindet sich eine handelsübliche Sicherheitsleiste. In der Regel wird die Sicherheitsleiste über eine Klebeschicht 1.4 am Chassis befestigt. Innerhalb des nicht leitenden Gummikörpers 1.2 befinden sich zwei elektrisch leitfähige Elemente, das erste leitfähige Element 1.5 und das zweite leitfähige Element 1.3. Der Hohlraum 1.6 isoliert im Normalfall die leitfähigen Elemente 1.5 und 1.3. Druck auf die Oberkante dieser Leiste verformt sie in der Art, das sich die beiden Elemente 1.5 und 1.3 berühren und einen elektrischen Kontakt bilden. Eine Elektronik wertet diesen Kontakt aus und reversiert z.B. einen Antriebsmotor.

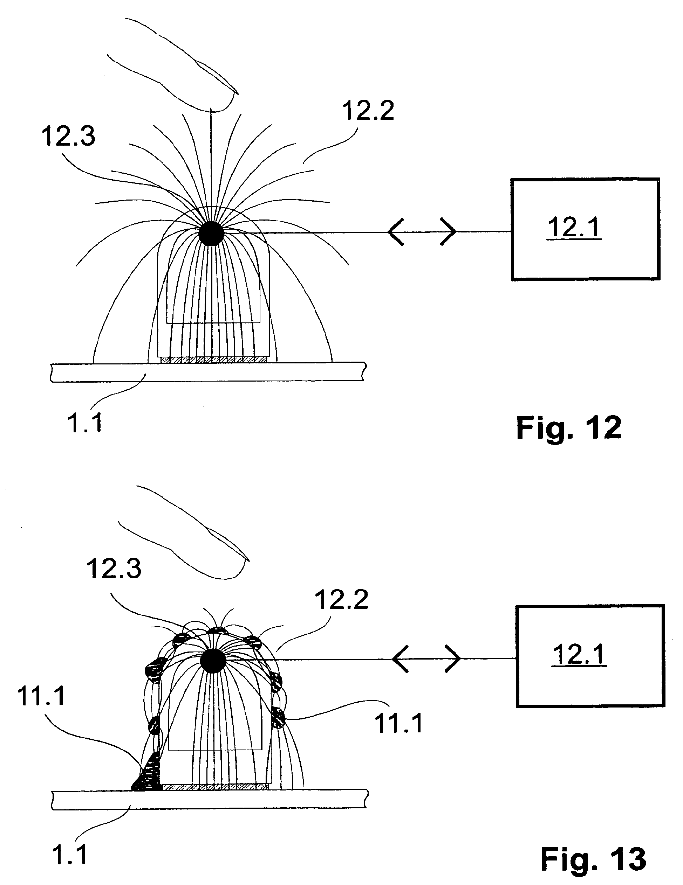

Bisherige kapazitive Systeme können zwar auch die leitfähigen Elemente 1.3 bzw. 1.5 einer Sicherheitsleiste zum Detektieren einer Handannäherung nutzen. Ein Vergleich zwischen bisherigen kapazitiven Messsystemen zum Erkennen einer Handannäherung und der hier vorgestellten Erfindung verdeutlicht jedoch die Wirkungsweise und den wesentlichen Vorteil der neuen Erfindung:
Bei bisherigen kapazitiven Sensoren wird ein elektrisch leitfähiges Element 12.3 direkt mit einer entsprechenden Sensorelektronik 12.1 (Fig. 12) verbunden. Diese lässt z.B. eine bestimmte Elektrizitätsmenge über einen Widerstand direkt in das leitfähige Element 12.3 fließen und bestimmt dann die Spannung an ihm. Verändert sich die umgebende Kapazität, so verändert sich auch die Spannung am aussendenden Element 12.3. Fig. 12 zeigt in stark vereinfachter Form die bei einem solchen System auftretenden Feldlinien 12.2 des aussendenden Elementes 12.3.

Fig. 13 zeigt in vereinfachter Form, dass Wassertropfen 11.1 oder ein Feuchtigkeitsfilm auf der Oberfläche der Sicherheitsleiste zwischen dem Element 12.3 und der Trägerfläche 1.1, z.B. dem Autochassis in erheblichem Maße die Kapazität verändern, so dass der Wasserfilm als deutliche Störung in Erscheinung tritt. Die Feldlinien 12.2 werden im Wesentlichen über den Weg von Wassertropfen zu Wassertropfen 11.1 direkt zur Trägerfläche 1.1 abgeleitet. Die Detektionsempfindlichkeit nimmt in diesem Fall stark ab.

Wesentlich in Erscheinung tritt bei bisherigen Systemen auch die Kapazität zwischen dem zweiten leitfähigen Element 1.3 und der Trägerfläche 1.1 aus Metall oder Kunststoff wie z.B. dem Fahrzeugchassis. Verschiedene Verfahren versuchen daher, die Kapazität zwischen dem zweiten leitfähigen Element 1.3 und der Trägerfläche 1.1 als Masse dadurch zu verringern, das sie das erste leitfähige Element 1.5 als sogenanntes "active ground" beschalten. Dazu wird das am zweiten leitfähigen Element 1.3 anliegende Signal hochohmig abgenommen und über einen Buffer niederohmig an das erste leitfähige Element 1.5 gelegt. Dieses verringert zwar die Kapazität zwischen dem zweiten leitfähigen Element 1.3 und der Trägerfläche 1.1, hilft jedoch nicht wesentlich gegen den Einfluss von Feuchtigkeit.

Die hier vorgestellte Erfindung verwendet als Basiselement auch eine solche Sicherheitsleiste. Die Erfindung beschränkt sich jedoch nicht auf diese Anordnung, auch andere Anordnungen der leitfähigen elektrischen Elemente sind möglich.

Dabei wird von folgender Überlegung ausgegangen: ein elektrisches Wechselsignal von zum Beispiel 70 KHz wird an das erste leitfähige Element 1.5 angelegt. Die Form des ersten leitfähigen Elements 1.5 ist gemäß Fig. 1 vorzugsweise flächig. Das Signal kann ein Rechteck- oder sinusförmiges Signal sein oder auch nur Pulsform aufweisen. Die Art des Signals hat keinen Einfluss, es muss nur von der nachfolgenden Elektronik entsprechend ausgewertet werden können. Die Treiberstufe für das elektrische Signal sollte entsprechend niederohmig sein, damit Kapazitäten zwischen dem ersten leitfähigen Element 1.5 und der Trägerfläche 1.1 nicht in Erscheinung treten. Im zweiten leitfähigen Element 1.3 erscheint über den kapazitiven Einfluss zwischen dem ersten leitfähigen Element 1.5 und dem zweiten leitfähigen Element 1.3 nahezu das gleiche Signal wie am aussendenden ersten leitfähigen Element 1.5.

Ein direkter Masseeinfluss zwischen zweiten leitfähigen Element 1.3 und Trägerfläche 1.1 tritt aufgrund des dazwischen liegenden aktiv treibenden, ersten leitfähigen Elements 1.5 nicht auf. Einzig die Kapazität gegenüber der umgebenden Luft oder in der Nähe der Sicherheitsleiste befindliche, aber nicht unter oder in unmittelbarer Nähe der leitfähigen Flächen des ersten leitfähigen Elements 1.5 liegende weitere leitfähige Flächen, z.B. Teile des Fahrzeugchassis, treten in Erscheinung. Da diese aber in der Regel größere Abstände zum zweiten leitfähigen Element 1.3 aufweisen als eine zu detektierende Hand 1.7, treten sie kaum in Erscheinung.

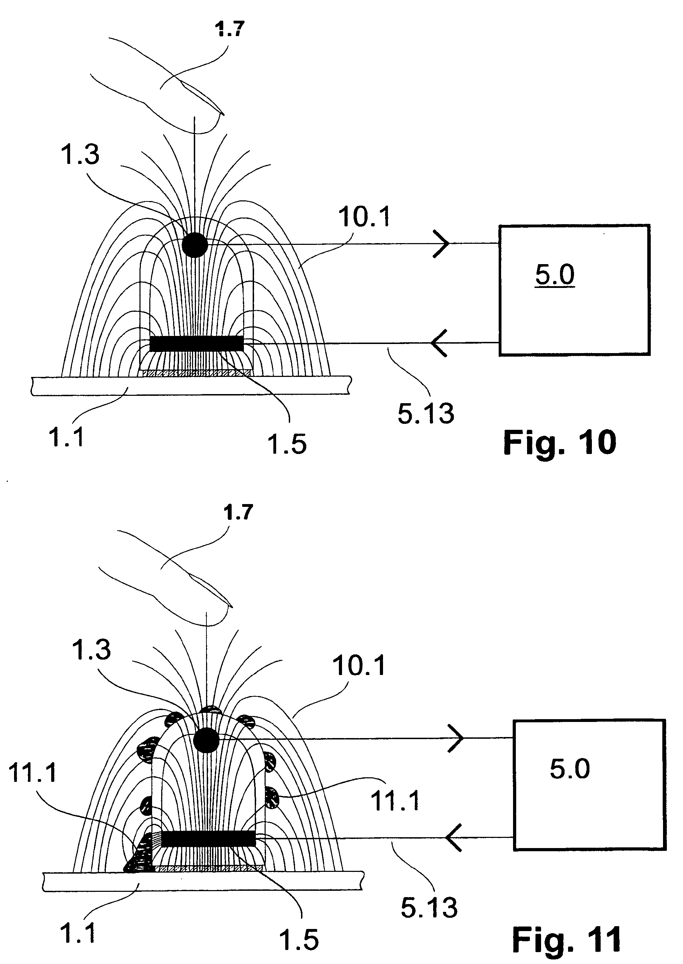

Fig. 10 verdeutlicht die Wirkungsweise. In grob vereinfachter Form sind die Feldlinien 10.1, ausgehend vom ersten leitfähigen Element 1.5, dargestellt. Ein Teil der Feldlinien des Taktsignals 5.13 treffen auf das zweite leitfähige Element 1.3. Da dieses Element keine wesentliche Verbindung zu einem weiteren Potenzial, z.B. der umgebenden Massefläche hat, baut sich in ihm nahezu die gleiche Signalspannung wie am aussendenden ersten leitfähigen Element 1.5 auf. Daher wird auch das zweite leitfähige Element 1.3 wiederum zu einem abstrahlenden Element. Wassertropfen 11.1 auf der Oberfläche der Sicherheitsleiste gemäß Fig. 11 nehmen ähnlich dem Element 1.3 die Feldlinien 10.1 auf und bilden wiederum ein abstrahlendes Element. Daher tritt bei Feuchtigkeit und Regentropfen keine Abnahme der Taktsignalspannung am Element 1.3 auf.

Eine Handannäherung verändert jedoch die Kapazität des zweiten leitfähigen Elements 1.3 zu einem Bezugspotenzial, z.B. der umgebenden Massefläche. Dadurch ändert sich auch der Spannungswert des empfangenen Taktsignals 5.13 am zweiten leitfähigen Element 1.3, was dann mittels geeigneter Elektronik ausgewertet werden kann. In der Praxis hat sich ergeben, dass bei einer dichten Benetzung der Oberfläche mit Regentropfen bei einer Bedeckung von 50% kein Einfluss auf die Taktsignalspannung am zweiten leitfähigen Element 1.3 auftrat. Ebensowenig wenn eine Betauung oder Raureif die Oberfläche benetzte. In allen Fällen war bei entsprechender Auswerteelektronik eine Handannäherung bei 50 mm Abstand detektierbar.

Es ergibt sich damit ein Verfahren zum Schutz gegen ein Einklemmen von Gegenständen oder Körperteilen 1.7 zwischen wenigstens zwei relativ zueinander beweglichen Teilen, von denen wenigstens einem Teil 1.1, 3.1 wenigstens eine Leiste 1.2, 3.2 zugeordnet ist. Die Leiste weist wenigstens zwei voneinander beabstandete, sich in Längsrichtung der Leiste erstreckende, leitfähige Elemente 1.3, 1.5 auf, die beide in der Leiste angeordnet sind. Damit ist sichergestellt, dass durch äußere Einflüsse hervorgerufene Kapazitätsänderungen durch eine Sensorelektronik 5.0 zur Erzeugung eines Ausgangssignals 5.16 in Folge veränderter Verhältnisse der leitfähigen Elemente zueinander abgegriffen werden können. Das wenigstens eine erste leitfähige Element 1.5 sendet ein Signal aus, das von wenigstens einem zweiten leitfähigen Element 1.3 durch den kapazitiven Einfluss des ersten leitfähigen Elements 1.5 empfangen wird, das im Wesentlichen auf demselben elektrischen Potenzial wie das erste leitfähige Element 1.5 das empfangene Signal ebenfalls aussendet.

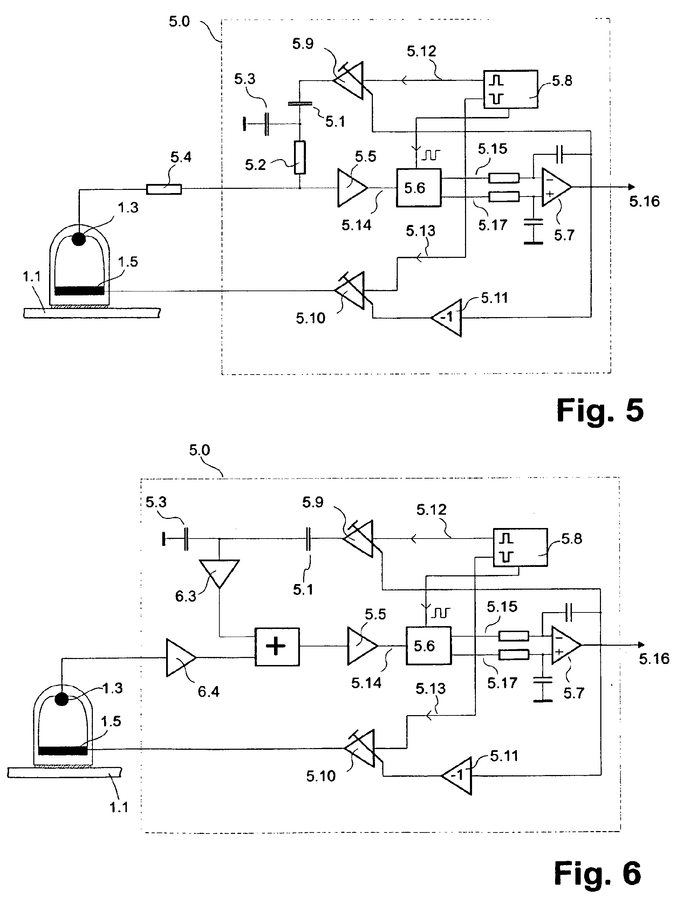

Ideal für die Realisierung der oben beschriebenen Erfindung hat sich das HALIOS-Verfahren gemäß der EP 706 648 B1 für die Erstellung der Sicherheitsleiste herausgestellt, dass in den Fig. 5 - 8 eingebunden ist. Es dient hier als Ausführungsbeispiel einer empfindlichen Sensorelektronik 5.0 für eine kapazitive Sicherheitsleiste.

Fig. 5 bis 8 verdeutlichen die Wirkungsweise. Ein Taktgenerator 5.8 liefert ein erstes Taktsignal 5.13 an einen ersten Amplitudenregler 5.10 und ein zweites invertiertes Taktsignal 5.12 an einen zweiten Amplitudenregler 5.9. Der niederohmige Ausgang des ersten Amplitudenreglers 5.10 ist an das erste leitfähige Element 1.5 angeschlossen. Dieses überträgt aufgrund kapazitiver Effekte das erste Taktsignal 5.13 auf das zweite leitfähige Element 1.3. Über den hochohmigen Summationswiderstand 5.4 wird das Signal des zweiten leitfähigen Elementes 1.3 auf den Eingang des Wechselspannungsverstärkers 5.5 gegeben. Das zweite, zum ersten Taktsignal 5.13 invertierte Taktsignal 5.12 wird über den zweiten Amplitudenregler 5.9 auf die Referenzreihenkapazität 5.1 und über einen zweiten hochohmigen Summationswiderstand 5.2 auf den Eingang des Wechselspannungsverstärkers 5.5 gegeben. Die Referenzreihenkapazität 5.1 sollte in etwa die gleiche Größe wie die Kapazität der leitfähigen Elemente 1.5 und 1.3 zueinander aufweisen. Eine auftretende Kapazität des ersten leitfähigen Elements 1.5 gegenüber der Umgebung, z.B. dem Fahrzeugchassis, kann durch den Parallelkondensator 5.3 ausgeglichen werden. Die Summationswiderstände 5.2 und 5.4 sollten vorzugsweise gleiche Werte aufweisen.

Bei entsprechender Amplitudenregelung heben sich die zuvor summierten Taktsignale 5.12 und 5.13 am Eingang des vorzugsweise als Wechselspannungsverstärker ausgebildeten Verstärkers 5.5 auf. Da der Verstärker 5.5 am Eingang im Idealfall nach dem gegenseitigen Auslöschen der Taktsignale lediglich Rauschen sieht, kann er sehr hoch verstärken, bzw. als hochverstärkender Begrenzerverstärker ausgeführt werden.

Das Ausgangssignal 5.14 des Verstärkers 5.5 wird dem Synchrondemodulator 5.6 zugeführt. Die den beiden Taktsignalen 5.12 und 5.13 zuordenbaren Ausgangssignale des Synchrondemodulators 5.6 werden vom integrierenden Komparator 5.7 auf Amplitudenunterschiede untersucht. Der Komparator kann als hochverstärkende Vergleicherschaltung ausgeführt sein. Jede noch so kleine Abweichung der Eingangsspannungen 5.15 und 5.17 führt zu einer entsprechenden Abweichung des Regelwertes 5.16 vom momentanen Wert. Die Amplitudenregler 5.9 und 5.10 werden mittels Invertierstufe 5.11 gegeneinander mit dem Regelwert 5.16 invertiert angesteuert. Steigt die Ausgangsamplitude eines Amplitudenreglers an, so fällt sie im anderen entsprechend ab. Somit wird das Eingangssignal des Wechselspannungsverstärkers 5.5 ständig auf "Null" gehalten, d.h., es sind keinerlei taktsynchrone Signalanteile enthalten.

Nähert sich z.B. eine Hand der Sicherheitsleiste, verändert sich die Kapazität des zweiten leitfähigen Elements 1.3 gegenüber der Umgebung. Diese zusätzliche Kapazität wirkt zusammen mit der Kapazität zwischen den leitfähigen Elementen 1.5 und 1.3 ähnlich einem kapazitiven Spannungsteiler und die Spannung am Element 1.3 nimmt entsprechend ab. Diese Abnahme führt am Eingang des Verstärkers 5.5 zur unvollständigen Auslöschung der Taktsignale 5.12 und 5.13. Nach der Synchrondemodulation im Synchrondemodulator 5.6 und Auswertung der Abweichung der Unterschiede in den separierten Signalanteilen der Eingangsspannungen 5.15 und 5.17 führt dies zu einer Abweichung des Regelwertes 5.16.

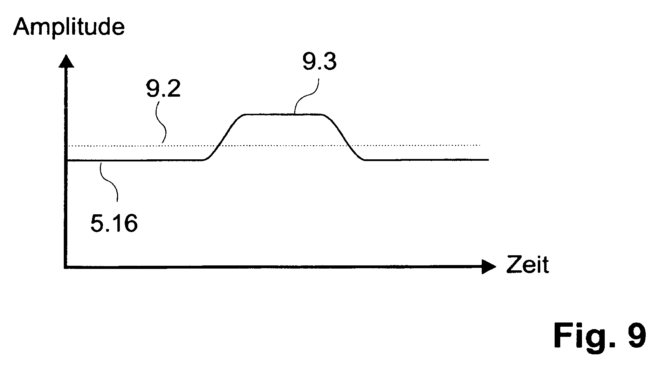

Fig. 9 zeigt den Regelwert 5.16 für das Ausführungsbeispiel Fig. 5 ohne eine Handannäherung. Erfolgt eine Annäherung einer Hand, verändert sich der Regelwert 5.16 hin zu einem höheren Regelwert 9.3. Die Abweichung im Regelwert 5.16 wird so lange gegenüber einem vorherigen Wert ansteigen bzw. abfallen, bis sich wieder am Eingang des Wechselspannungsverstärkers 5.5 das Taktsignal 5.13 und das invertierte Taktsignal 5.12 vollständig aufheben.

Im Ausführungsbeispiel steigt der Regelwert bei Handannäherung an. Eine zeichnerisch nicht dargestellte Auswertelogik kann dann z.B. mittels eines Schwellwertes 9.2 eine Auswertung des Regelwertes 5.16 vornehmen. Wird der Schwellwert 9.2 überschritten, gilt dies als "Einklemmrisiko" und eine mechanische Bewegung kann entsprechend gestoppt bzw. reversiert werden.

Mit dieser Anordnung kann die Annäherung an oder das Aufliegen eines beliebigen kapazitiv wirksamen Gegenstandes auf einer Sicherheitsleiste detektiert werden.

Im Übrigen können die im Ausführungsbeispiel beschriebenen Summationswiderstände 5.2 bzw. 5.4 auch durch Kondensatoren bzw. Reihenschaltungen aus Widerstand und Kondensator ersetzt werden. Vorteilhaft können die Summationswiderstände 5.2 und 5.4 gemäß Fig. 6 auch durch Impedanzwandler 6.3 bzw. 6.4 mit hochohmigen Eingang ausgeführt werden. Durch die aktive Beschaltung wird das Nutzsignal am zweiten leitfähigen Element 1.3 nicht belastet.

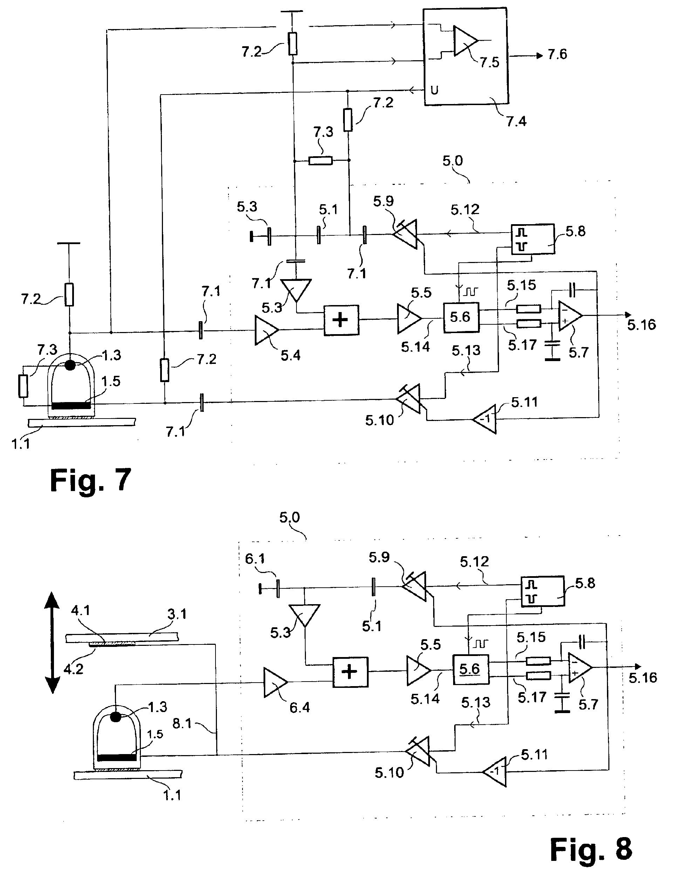

Eine Möglichkeit zur Überwachung der Sicherheitsleiste auf mechanische Beschädigungen zeigt das Ausführungsbeispiel der Fig. 7. Die Auswerteelektronik der Leitungsüberwachung 7.4 stellt eine Spannung bereit, die über die Widerstände 7.2 und 7.3 am Eingang einer Auswerteschaltung 7.5 zu entsprechenden Spannungen führen. Am mechanischen Ende der Sicherheitsleiste befindet sich der Abschlusswiderstand 7.3. Eine Unterbrechung des Stromflusses durch eine mechanische Beschädigung führt zu einer Spannungsveränderung am Eingang der Auswerteschaltung 7.5. Gleiches gilt für ein mechanisches Zusammendrücken der Sicherheitsleiste, so dass die elektrisch leitenden Elemente 1.5 und 1.3 sich berühren. Beide Zustände führen zu einer entsprechenden Ausgangsinformation 7.6. der Leitungsüberwachung. Die Kondensatoren 7.1 dienen lediglich als Abblockkondensatoren zur Gleichspannungsentkoppelung.

Die beschriebene Erfindung bietet noch einen weiteren Vorteil:
Bei einem Einklemmschutz am Beispiel bei einer automatisch schließenden Fahrzeugscheibe fährt eine, im Verhältnis zu einem Finger kapazitiv wenig wirksame Glasscheibe auf die Sicherheitsleiste zu. Der Regelwert 5.16 verändert sich dadurch entsprechend wenig. Anders ist es, wenn der Einklemmschutz z.B. bei einer metallischen Heckklappe angebracht wird. Das Schließen dieser Heckklappe führt naturgemäß insbesondere bei kleinen Abständen von metallischer Heckklappe zum ersten leitfähigen Element 1.3 (Fig.1) zu einer starken Veränderung der Kapazität. Die dadurch entstehende Änderung der Regelwertes 5.16 kann so groß werden, dass die zusätzliche Wertänderung durch einen die Sicherheitsleiste berührenden kleinen Kinderfinger überdeckt würde.

Zur Unterdrückung einer Regelwertveränderung beim Schließen der Heckklappe kann die Sicherheitsleiste in mindestens zwei Bereiche, die vorzugsweise symmetrisch zur schließenden Heckklappe angebracht sein sollten, aufgeteilt werden. Dazu wird der im Ausführungsbeispiel der Fig. 5 vorgesehene Referenzzweig, bestehend aus Referenzreihenkapazität 5.1 und Parallelkondensator 5.3, durch den zweiten Bereich der Sicherheitsleiste ersetzt. Ein Schließen der Heckklappe wirkt sich dann auf beide Bereiche gleich aus, so dass nur die Differenz gemessen werden muss. Im Ausführungsbeispiel bedeutet das im Einklemmfall eine Regelwertabweichung hin zu höheren oder zu niedrigeren Werten. Ohne einen "Finger" verändern sich die Kapazitätswerte beider Bereiche der Sicherheitsleiste beim Schließen der Heckklappe gleich, sodass der Regelwert 5.16 sich nicht verändert.

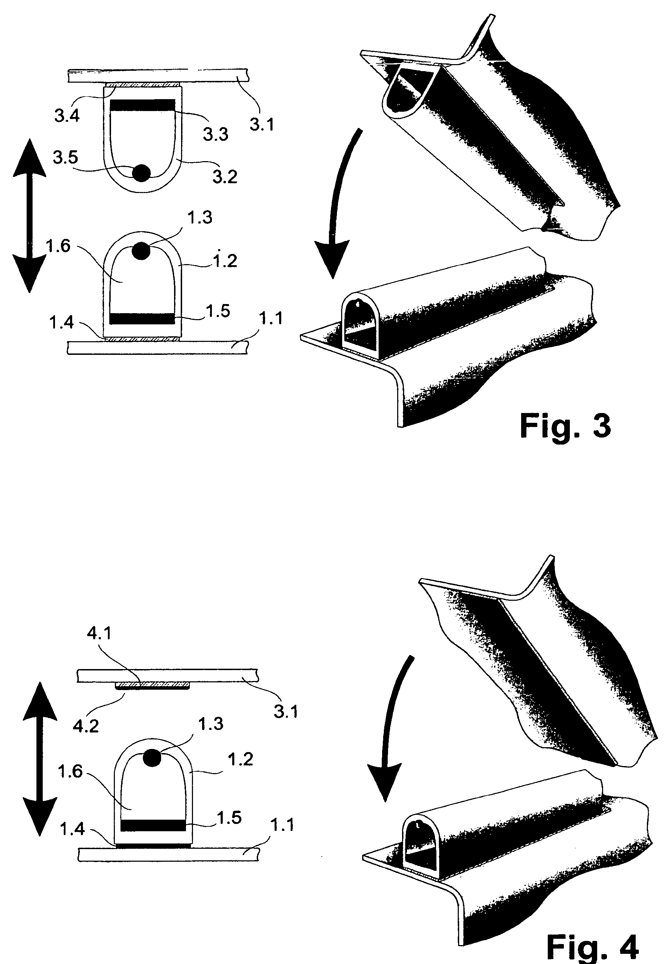

Eine Alternative zu dieser Lösung zeigt Fig. 3. Eine weitere Sicherheitsleiste 3.2 wird am beweglichen Element 3.1 angebracht. Die aussendenden leitfähigen Elemente 1.5 und 3.3 sind elektrisch miteinander verbunden, ebenso die empfangenden Elemente 1.3 und 3.5. Beim Schließen der Heckklappe nähern sich die beiden Sicherheitsleisten. Eine Änderung der Signalspannung am leitenden Element 2.5 oder 1.3 durch eine Kapazitätsänderung erfolgt jetzt aus vorbenannten Gründen nicht mehr. Lediglich ein mechanisches Zusammendrücken der Sicherheitsleiste sollte vermieden werden.

Eine weitere Vereinfachung dieser Schaltungsanordnung ergibt sich gemäß Fig. 4, wenn die schließende Heckklappe, das bewegliche Element 3.1 nur mit einem dünnen leitfähigen flächigen Element 4.2 versehen ist. Eine nicht leitende Fläche, z. B. ein Klebestreifen 4.1, isoliert das leitfähige flächige Element 4.2 gegenüber der Metallfläche des beweglichen Elementes 3.1. Elektrisch sind das leitfähige Element 4.2 und das erste leitfähige Element 1.5 über Leitung 8.1 verbunden. Jedoch kann das leitfähige Element 4.2 auch über einen Spannungsteiler an das Signal für das leitfähige Element 1.5 angeschlossen sein, um eventuelle Signalabschwächungen z.B. durch den Summationswiderstand 5.4 (Fig. 5) auszugleichen. Eine weitere Möglichkeit besteht auch darin, das leitfähige Element 4.2 auf das gleiche elektrische Potenzial wie das zweite leitfähige Element 1.3 zu legen. Dazu wird das Signal am zweiten leitfähigen Element 1.3 hochohmig abgenommen und über einen Impedanzwandler an das leitfähige Element 4.2 gelegt. Maßgeblich ist jedoch, dass bei Schließen der Heckklappe, also bei Annähern des leitfähigen Elements 4.2 an die Sicherheitsleiste 1.2 keine Änderung des Regelwertes 5.16 stattfindet. Ein Finger im Einklemmbereich verändert die Kapazität des Elementes 1.3 gegenüber der Umgebung und wird daher sicher erkannt.

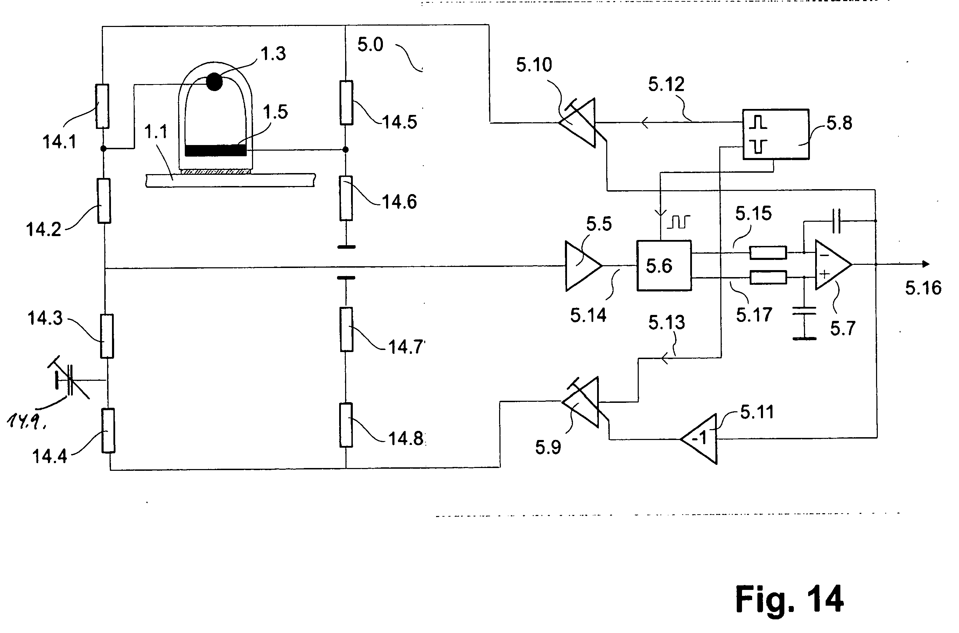

Fig. 14 zeigt ein Blockschaltbild, in dem der Anschluss der Sicherheitsleiste alternativ über Spannungsteiler erfolgt. Das erste leitfähige Element 1.5 ist dazu über den aus den Widerständen 14.5, 14.6 gebildeten Spannungsteiler eingangsseitig mit der Sensorelektronik 5.0 verbunden, während das zweite leitfähige Element 1.3 ausgangsseitig über den durch die Widerstände 14.1, 14.2 gebildeten Spannungsteiler mit der Sensorelektronik und der Empfangsseite der Sensorelektronik 5.0 verbunden ist. Auf der Referenzseite bilden die Widerstände 14.7, 14.8 einen Spannungsteiler aus, der analog zu dem durch die Widerstände 14.5, 14.6 gebildeten Spannungsteiler aufgebaut ist, und die Widerstände 14.3, 14.4 bilden einen Spannungsteiler aus, der analog zum Spannungsteiler ist, der durch die Widerstände 14.1 und 14.2 gebildet wird. Eine Regelung dahingehend, dass am Eingang des Wechselspannungsverstärkers 5.5 aus der Schaltung der Sicherheitsleiste als auch aus der Referenzstrecke in der Summe ein Nullsignal vorliegt, erfolgt über die Amplitudenregler 5.9 und 5.10 und kann auch über die Regelkapazität 14.9 erfolgen.

Der Anschluss erfolgt dabei in Richtung Sender, also in Richtung auf das erste leitfähige Element 1.5 niederohmig, so dass die Widerstände 14.5, 14.6 und analog dazu die Widerstände 14.7, 14.8 zum Beispiel einen Wert von 100 Ohm haben. Empfangsseitig, das heißt ausgehend vom zweiten leitfähigen Element 1.3 erfolgt der Anschluss hochohmig, so dass die Widerstände 14.1, 14.2 und analog auf der Referenzseite die Widerstände 14.3, 14.4 zum Beispiel einen Widerstand von 100 KOhm aufweisen können.

Wenn auf der Sicherheitsleiste Wassertropfen auftreten, bildet sich eine Kapazität von den Wassertropfen nach Masse also zur Trägerfläche 1.1 und eine Kapazität in Richtung zur Empfangsseite aus. Dadurch, dass der Empfänger hochohmig angeschlossen ist, ist ein Kurzschluss zur Masse nicht zu spüren. Dadurch, dass die Kapazität zum Empfänger hochohmig ist, sind die Wassertropfen in diesem Fall insbesondere deshalb in der Messung vernachlässigbar, weil der Spannungsteiler auf beiden Seiten der Sicherheitsleiste zur gleichen Spannung führt. Bei einer idealen Doppelbrücke mit identischen Treiberstufen bildet sich damit in Folge von Wassertropfen keine Kapazität aus. Die Annäherung eines Objekts führt jedoch zu einer Änderung der Kapazität, die erkennbar ist.

Die hier beschriebene Anordnung kann selbstverständlich auch für Dreh- und Schiebetüren sowie alle weiteren Anwendungen im Bereich Einklemmschutz oder Personen Früherkennung, bei der es auf Unabhängigkeit von Spritzwasser oder Feuchtigkeit ankommt, eingesetzt werden.

### Bezugszeichenliste

- 1.1: Trägerfläche
- 1.2: Gummikörper der Sicherheitsleiste
- 1.3: zweites elektrisch leitfähiges Element
- 1.4: Klebeschicht
- 1.5: erstes elektrisch leitfähiges Element
- 1.6: Hohlraum
- 1.7: sich annähernder Finger
- 3.1: bewegliches Element, z.B. Heckklappe
- 3.2: weitere Sicherheitsleiste
- 3.3: erstes leitfähige Element der zweiten Sicherheitsleiste
- 3.4: Kleber der zweiten Sicherheitsleiste
- 3.5: zweites leitfähige Element der zweiten Sicherheitsleiste
- 4.1: Klebestreifen
- 4.2: leitfähiges flächiges Element
- 5.0: Sensorelektronik
- 5.1: Referenzreihenkapazität
- 5.2: Summationswiderstand
- 5.3: Parallelkondensator
- 5.4: Summationswiderstand
- 5.5: Wechselspannungsverstärker
- 5.6: Synchrondemodulator
- 5.7: integrierender Komparator
- 5.8: Taktgenerator
- 5.9: zweiter Amplitudenregler
- 5.10: erster Amplitudenregler
- 5.11: Invertierstufe
- 5.12: zweites invertiertes Taktsignal
- 5.13: erstes Taktsignal
- 5.14: Vorverstärker-Ausgangssignal
- 5.15: separierter Signalanteil eines ersten Taktsignals
- 5.16: Regelwert
- 5.17: separierter Signalanteil eines zweiten Taktsignals
- 6.3: Impedanzwandler
- 6.4: Impedanzwandler
- 7.1: Abblockkondensator
- 7.2: Widerstand
- 7.3': Abschlusswiderstand
- 7.4: Auswerteelektronik der Leitungsüberwachung
- 7.5: Auswerteschaltung
- 7.6.1: Ausgangsinformation der Leitungsüberwachung
- 8.1: Leitung
- 9.2: Schwellwert
- 9.3: höherer Regelwert bei Annäherung einer Hand
- 10.1: Feldlinien des aussendenden Elementes 1.5
- 11.1: Wassertropfen
- 12.1: Sensorelektronik
- 12.2: Feldlinien des aussendenden Elementes 12.3
- 12.3: Aussendendes Element
- 14.1 ... 14.8: Widerstände der Spannungsteiler
- 14.9: Regelkondensator

## Patentansprüche

1. Verfahren zum Schutz gegen ein Einklemmen von Gegenständen oder Körperteilen (1.7) zwischen wenigstens zwei relativ zueinander beweglichen Teilen, von denen wenigstens einem Teil (1.1, 3.1) wenigstens eine auf einer Trägerfläche (1.1) angebrachte Leiste (1.2, 3.2) zugeordnet ist, die wenigstens zwei voneinander beabstandete, sich in Längsrichtung der Leiste erstreckende, leitfähige Elemente (1.3, 1.5) aufweist, die beide in der Leiste angeordnet sind, sowie mit einer Sensorelektronik (5.0) zur Erzeugung eines Ausgangssignals einer in Folge äußerer Einflüsse veränderbaren Kapazität,
wobei wenigstens ein erstes leitfähiges Element (1.5) ein Signal aussendet, das von wenigstens einem zweiten leitfähigen Element (1.3) durch kapazitive Kopplung mit dem ersten leitfähigen Elements (1.5) empfangen wird, wobei das zweite leitfähige Element (1.3) zur Vermittlung einer Kapazitätsänderung an die Sensorelektronik (5.0) in Folge der äußeren Einflüsse mit dieser verbunden ist,
**dadurch gekennzeichnet, dass** das zweite leitfähige Element (1.3) zur Vermittlung einer Kapazitätsänderung an die Sensorelektronik (5.0) in Folge der äußeren Einflüsse mit dieser über einen hochohmigen Widerstand verbunden ist, wobei das erste leitfähige Elements (1.5) zwischen der Trägerfläche (1.1) und dem zweiten leitfähigen Element (1.3) angeordnet ist und das zweite leitfähige Element (1.3) im Wesentlichen auf demselben elektrischen Potenzial wie das erste leitfähige Element (1.5) das empfangene Signal ebenfalls aussendet.

2. Verfahren nach Anspruch 1, **gekennzeichnet durch** das Anordnen des zweiten leitfähigen, kapazitiv ans aktiv treibende, erste leitfähige Element (1.5) gekoppelten Elements (1.3), das mit der Auswerteschaltung der Sensorelektronik in Verbindung steht, in einer größeren Entfernung von der Trägerfläche (1.1) als das erste leitfähige Element (1.5).

3. Verfahren nach Anspruch 1 oder 2, **dadurch gekennzeichnet, dass** das erzeugte Ausgangssignal durch ein durch äußere Einflüsse veränderbares Verhältnis der leitfähigen Elemente (1.3, 1.5) zueinander, insbesondere ein Verhältnis der an den leitfähigen Elementen anliegenden Spannungen beeinflusst wird.

4. Verfahren nach einem der vorhergehenden Ansprüche, **dadurch gekennzeichnet, dass** die Annäherung eines Objekts die Kapazität des zweiten leitfähigen Elements (1.3) zu einem Bezugspotenzial verändert.

5. Verfahren nach einem der vorhergehenden Ansprüche, **dadurch gekennzeichnet, dass** das erste leitfähige Element (1.5) niederohmig an die Sensorelektronik (5.0) angekoppelt wird.

6. Verfahren nach einem der vorhergehenden Ansprüche, **dadurch gekennzeichnet, dass** die Sensorelektronik (5.0) eine geometrische Veränderung der leitfähigen Elemente zueinander als weiteres Ausgangssignal für den Einklemmschutz erfasst.

7. Verfahren nach einem der vorhergehenden Ansprüche, **dadurch gekennzeichnet, dass** an jedem der wenigstens zwei relativ zueinander beweglichen Teile eine Leiste (1.2, 3.2) angeordnet wird, wobei die Leisten elektrisch parallel zueinander geschalten sind, oder dass an wenigstens einem Teil (3.1) der wenigstens zwei relativ zueinander beweglichen Teile ein vorzugsweise flächiges leitfähiges Element (4.2) gegenüber dem Teil isoliert angeordnet ist, das zum ersten leitfähigen Element (1.5) parallel geschalten ist.

8. Verfahren nach einem der vorhergehenden Ansprüche, **dadurch gekennzeichnet, dass** die Taktsteuerung (5.8) dem ersten leitfähigen Element (1.5) das Taktsignal zur Aussendung zuleitet, das vom zweiten leitfähigen Element (1.3) empfangen wird, wobei das empfangene Signal durch äußere Einflüsse beeinflusst und mit dem invertierten Taktsignal überlagert ein Eingangssignal bildet, und
dass das Eingangssignal taktweise so zergliedert wird, dass an den Eingängen eines Vergleichers (5.7) das taktweise zerlegte Signal zur Bildung eines Vergleichswerts als Regelwert (5.16) ansteht, und
dass im Signalgang des Taktsignals und/oder des invertierten Taktsignals wenigstens ein Amplitudenregler (5.9, 5.10) vorgesehen ist, der zur Regelung der Amplitudenwerte der Taktsignale den Regelwert (5.16) so verwendet, dass die Amplituden des taktweise zerlegten Eingangssignals zueinander im Wesentlichen gleich groß sind, so dass das Eingangssignal keine taktsynchronen Anteile enthält.

9. Verfahren nach einem der vorhergehenden Ansprüche, **dadurch gekennzeichnet, dass** das erste leitfähige Element eingangsseitig und das zweite leitfähige Element ausgangsseitig an einem Spannungsteiler angeschlossen wird.

10. Einklemmschutz zum Schutz gegen ein Einklemmen von Gegenständen oder Körperteilen (1.7) zwischen wenigstens zwei relativ zueinander beweglichen Teilen, von denen wenigstens einem Teil (1.1, 3.1) wenigstens eine an einer Trägerfläche (1.1) angebrachte Leiste (1.2, 3.2) zugeordnet ist, die wenigstens zwei voneinander beabstandete, sich in Längsrichtung der Leiste erstreckende, leitfähige Elemente (1.3, 1.5) aufweist, die beide in der Leiste angeordnet sind, sowie mit einer Sensorelektronik (5.0) zur Erzeugung eines Ausgangssignals in Folge äußerer Einflüsse, wobei wenigstens ein erstes leitfähiges Element (1.5) als aussendendes Element zum Aussenden eines Signals ausgebildet ist und wenigstens ein zweites leitfähiges Element (1.3) durch kapazitive Kopplung mit dem ersten leitfähigen Element (1.5) als empfangendes Element ausgebildet ist, wobei das zweite leitfähige Element (1.3) zur Vermittlung einer Kapazitätsänderung an die Sensorelektronik (5.0) in Folge der äußeren Einflüsse mit dieser verbunden ist,
**dadurch gekennzeichnet, dass** das zweite leitfähige Element (1.3) zur Vermittlung einer Kapazitätsänderung an die Sensorelektronik (5.0) in Folge der äußeren Einflüsse mit dieser über einen hochohmigen Widerstand verbunden ist, wobei das erste leitfähige Elements (1.5) zwischen der Trägerfläche (1.1) und dem zweiten leitfähigen Element (1.3) angeordnet ist und dass mittels der Sensorelektronik (5.0) das zweite leitfähige Element (1.3) sich im Wesentlichen auf demselben elektrischen Potenzial wie das erste leitfähige Element (1.5) befindet und als aussendendes Element das empfangene Signal ebenfalls aussendet.

11. Einklemmschutz nach Anspruch 10, **dadurch gekennzeichnet, dass** das zweite leitfähige, kapazitiv ans aktiv treibende, erste leitfähige Element (1.5) gekoppelte Element (1.3), das mit der Auswerteschaltung der Sensorelektronik in Verbindung steht, von der Trägerfläche (1.1) weiter entfernt ist als das erste leitfähige Element (1.5).

12. Einklemmschutz nach Anspruch 10 oder 11, **dadurch gekennzeichnet, dass** das Ausgangssignal von einem durch äußere Einflüsse veränderbaren Verhältnis der leitfähigen Elemente (1.3, 1.5) zueinander, insbesondere einem Verhältnis der an den leitfähigen Elementen anliegenden Spannungen abhängt.

13. Einklemmschutz nach einem der Ansprüche 10 bis 12, **dadurch gekennzeichnet, dass** das erste leitfähige Element (1.5) niederohmig an die Sensorelektronik (5.0) gekoppelt ist.

14. Einklemmschutz nach einem der Ansprüche 10 bis 13, **dadurch gekennzeichnet, dass** die Sensorelektronik (5.0) so ausgebildet ist, dass sie die geometrische Veränderung der leitfähigen Elemente zueinander als weiteres Ausgangssignal für den Einklemmschutz erfasst.

15. Einklemmschutz nach einem der Ansprüche 10 bis 14, **dadurch gekennzeichnet, dass** an jedem der wenigstens zwei relativ zueinander beweglichen Teile eine Leiste (1.2, 3.2) angeordnet ist, wobei die Leisten elektrisch parallel zueinander geschalten sind, oder dass an wenigstens einem Teil (3.1) der wenigstens zwei relativ zueinander beweglichen Teile ein vorzugsweise flächiges leitfähiges Element (4.2) isoliert gegenüber dem Teil angeordnet ist, das zum ersten leitfähigen Element (1.5) mit im Wesentlichen gleichen Signal elektrisch parallel geschalten ist.

16. Einklemmschutz nach einem der Ansprüche 10 bis 15, **dadurch gekennzeichnet, dass** eine Taktsteuerung (5.8) vorgesehen ist, die ein Taktsignal an das erste leitfähige Element (1.5) leitet und ein invertiertes Taktsignal als elektrisches Signal mit dem vom zweiten leitfähigen Element (1.3) empfangenen Signal überlagert.

17. Einklemmschutz nach einem der Ansprüche 10 bis 16, **dadurch gekennzeichnet, dass** die Leiste (1.2, 3.2) in wenigstens zwei gleiche, vorzugsweise symmetrisch zueinander angeordnete Teile aufgeteilt ist, die sich gegenseitig referenzieren.

18. Einklemmschutz nach einem der Ansprüche 10 bis 17, **dadurch gekennzeichnet, dass** die Taktsteuerung (5.8) so in der Sensorelektronik (5.0) eingebunden ist, dass dem ersten leitfähige Element (1.5) das Taktsignal zur Aussendung zugeleitet ist, das vom zweiten leitfähigen Element (1.3) empfangen wird, wobei das empfangene Signal durch äußere Einflüsse beeinflusst und mit dem invertierten Taktsignal überlagert ein Eingangssignal bildet, und
dass ein Synchrondemodulator (5.6) zur taktweisen Zuordnung des Eingangssignals so vorgesehen ist, dass an den Eingängen eines Vergleichers (5.7) das taktweise zerlegte Signal zur Bildung eines Vergleichswerts als Regelwert (5.16) ansteht, und
dass im Signalgang des Taktsignals und/oder des invertierten Taktsignals wenigstens ein Amplitudenregler (5.9, 5.10) vorgesehen ist, der zur Regelung der Amplitudenwerte der Taktsignale den Regelwert (5.16) so verwendet, dass die Amplituden des taktweise zerlegten Eingangssignals zueinander im Wesentlichen gleich groß sind, so dass das Eingangssignal keine taktsynchronen Anteile enthält.

19. Einklemmschutz nach einem der Ansprüche 10 bis 18, **dadurch gekennzeichnet, dass** das erste leitfähige Element eingangsseitig und das zweite leitfähige Element ausgangsseitig an einem Spannungsteiler angeschlossen ist.

## Claims

1. A method for preventing objects or parts of the body (1.7) from being trapped between at least two mutually relatively moveable parts, of which at least one part (1.1, 3.1) has associated therewith at least one strip (1.2, 3.2) which is mounted on a supporting surface (1.1) and comprises at least two mutually spaced conductive elements (1.3, 1.5), that extend in the longitudinal direction of the strip and both of which are arranged in the strip, and also an electronic sensor system (5.0) for producing an output signal for a capacitance the value of which is adapted to vary as a result of external influences,
wherein at least one first conductive element (1.5) sends out a signal, which is received by at least one second conductive element (1.3) due to capacitive coupling with the first conductive element (1.5), wherein the second conductive element (1.3) is connected to the electronic sensor system (5.0) for the purposes of relaying a change of capacitance resulting from the external influences on the electronic sensor system,
**characterized in that** the second conductive element (1.3) is coupled in high impedance manner to the electronic sensor system (5.0) for the purposes of relaying a change of capacitance resulting from the external influences on the electronic sensor system, wherein the first conductive element (1.5) is arranged between the supporting surface (1.1) and the second conductive element (1.3) and the second conductive element (1.3) at substantially the same electrical potential as the first conductive element (1.5) likewise sends out the received signal.

2. A method in accordance with Claim 1, **characterized by** the arrangement of the second conductive element (1.3), which is capacitively coupled to the actively driving first conductive element (1.5) and connected to the evaluation circuit of the electronic sensor system, at a greater distance from the supporting surface (1.1) than the first conductive element (1.5).

3. A method in accordance with Claim 1 or 2, **characterized in that** the generated output signal is affected by a relationship between the conductive elements (1.3, 1.5) to each other, especially a relationship between the voltages present on the conductive elements, the relationship being variable by external influences.

4. A method in accordance with one of the preceding Claims, **characterized in that** the approach of an object alters the capacitance of the second conductive element (1.3) relative to a reference potential.

5. A method in accordance with one of the preceding Claims, **characterized in that** the first conductive element (1.5) is coupled in low impedance manner to the electronic sensor system (5.0).

6. A method in accordance with one of the preceding Claims, **characterized in that** the electronic sensor system (5.0) detects a geometrical change of the conductive elements relative to one another as a further output signal for the trapping prevention arrangement.

7. A method in accordance with one of the preceding Claims, **characterized in that** at least one strip (1.2, 3.2) is arranged on each of the at least two mutually relatively moveable parts, wherein the strips are connected together electrically in parallel, or **in that** a preferably planar conductive element (4.2) is arranged on at least one part (3.1) of the at least two mutually relatively moveable parts, said element being insulated with respect to said one part and connected in parallel with the first conductive element (1.5).

8. A method in accordance with one of the preceding Claims, **characterized in that** the clock control system (5.8) supplies the first conductive element (1.5) with the clock signal which is to be sent out thereby and then received by the second conductive element (1.3), wherein the received signal that is affected by external influences and has the inverted clock signal superimposed thereon forms an input signal, and
**in that** the input signal is analysed in clocked manner in such a way that the signal which has been analysed in clocked manner is present at the inputs of a comparator (5.7) for the purposes of forming a comparative value as a control value (5.16), and
**in that** at least one amplitude regulator (5.9, 5.10) is provided in the signal path of the clock signal and/or the inverted clock signal, said amplitude regulator utilising the control value (5.16) for the purposes of regulating the amplitude values of the clock signals in such a way, that the amplitudes of the input signal which has been analysed in clocked manner are substantially of the same size as each other, so that the input signal does not contain any clock synchronous components.

9. A method in accordance with one of the preceding Claims, **characterized in that** the input side of the first conductive element and the output side of the second conductive element are connected to a voltage divider.

10. A crush protection arrangement for preventing objects or parts of the body (1.7) from being trapped between at least two mutually relatively moveable parts, of which at least one part (1.1, 3.1) has associated therewith at least one strip (1.2, 3.2), which is mounted on a supporting surface (1.1) and comprises at least two mutually spaced conductive elements (1.3, 1.5) that extend in the longitudinal direction of the strip and both of which are arranged in the strip, and also an electronic sensor system (5.0) for producing an output signal as a result of external influences,
wherein at least one first conductive element (1.5) is in the form of an emitting element for sending out a signal and wherein at least one second conductive element (1.3) is in the form of a receiving element due to capacitive coupling with the first conductive element (1.5) and is connected to the electronic sensor system (5.0) for the purposes of relaying a change of capacitance resulting from the external influences on the electronic sensor system, **characterized in that** the second conductive element (1.3) is coupled in high impedance manner to the electronic sensor system (5.0) for the purposes of relaying a change of capacitance resulting from the external influences on the electronic sensor system, wherein the first conductive element (1.5) is arranged between the supporting surface (1.1) and the second conductive element (1.3), and **in that**, by means of the electronic sensor system, the second conductive element (1.3) is at substantially the same electrical potential as the first conductive element (1.5) and is in the form of an emitting element, which likewise sends out the received signal

11. A crush protection arrangement in accordance with Claim 10, **characterized in that** the second conductive element (1.3), which is capacitively coupled to the actively driving first conductive element (1.5) and connected to the evaluation circuit of the electronic sensor system, is located at a greater distance from the supporting surface (1.1) than the first conductive element (1.5).

12. A crush protection arrangement in accordance with Claim 10 or 11, **characterized in that** the output signal depends on a relationship between the conductive elements (1.3, 1.5) to each other, especially a relationship between the voltages present on the conductive elements, the relationship being variable by external influences.

13. A crush protection arrangement in accordance with one of the Claims 10 to 12, **characterized in that** the first conductive element (1.5) is coupled in low impedance manner to the electronic sensor system (5.0).

14. A crush protection arrangement in accordance with one of the Claims 10 to 13, **characterized in that** the electronic sensor system (5.0) is formed in such a way that it detects the geometrical change of the conductive elements relative to one another as a further output signal for the crush protection arrangement.

15. A crush protection arrangement in accordance with one of the Claims 10 to 14, **characterized in that** a strip (1.2, 3.2) is arranged on each of the at least two mutually relatively moveable parts, wherein the strips are connected together electrically in parallel, or **in that** a preferably planar conductive element (4.2) is arranged on at least one part (3.1) of the at least two mutually relatively moveable parts, said element being insulated with respect to said one part and connected electrically with substantially identical signal in parallel with the first conductive element (1.5).

16. A crush protection arrangement in accordance with one of the Claims 10 to 15, **characterized in that** there is provided a clock control system (5.8) which feeds a clock signal pulse to the first conductive element (1.5) and superimposes a signal received by the second conductive element (1.3) on an inverted clock signal in the form of an electrical signal.

17. A crush protection arrangement in accordance with one of the Claims 10 to 16, **characterized in that** the strip (1.2, 3.2) is divided up into at least two equal, preferably mutually symmetrically arranged parts, which serve as mutual references.

18. A crush protection arrangement in accordance with one of the Claims 10 to 17, **characterized in that** the clock control system (5.8) is integrated into the electronic sensor system (5.0) in such a way that the clock signal that is to be sent out thereby and received by the second conductive element (1.3) is supplied to the first conductive element (1.5), wherein the received signal that is affected by external influences and has the inverted clock superimposed thereon forms an input signal, and
**in that** a synchronous demodulator (5.6) for the clocked allocation of the input signal is provided in such a way that the signal which has been analysed in clocked manner is present at the inputs of a comparator (5.7) for the purposes of forming a comparison value in the form of a control value (5.16), and
**in that** at least one amplitude regulator (5.9, 5.10) is provided in the signal path of the clock signal and/or the inverted clock signal, said amplitude regulator utilising the control value (5.16) for the purposes of regulating the amplitude values of the clock signals in such a way, that the mutual amplitudes of the input signal which has been analysed in clocked manner are substantially of the same size as each other, so that the input signal does not contain any clock synchronous components.

19. A crush protection arrangement in accordance with one of the Claims 10 to 18, **characterized in that** the input side of the first conductive element and the output side of the second conductive element are connected to a voltage divider.

## Revendications

1. Procédé de protection contre le pincement d'objets ou de membres (1.7) entre au moins deux pièces mobiles l'une par rapport à l'autre, à une partie (1.1, 3.1) au moins desquelles est associée au moins une tringle (1.2, 3.2) placée sur une surface de support (1.1), laquelle tringle présente au moins deux éléments conducteurs (1.3, 1.5) espacés l'un de l'autre, s'étendant dans le sens longitudinal de la tringle et disposés tous les deux dans la tringle, avec également une électronique de détection (5.0) pour la production d'un signal de sortie d'une capacité variable en fonction d'influences extérieures,
dans lequel au moins un premier élément conducteur (1.5) émet un signal qui est reçu par au moins un deuxième élément conducteur (1.3) par couplage capacitif avec le premier élément conducteur (1.5), le deuxième élément conducteur (1.3) étant relié à l'électronique de détection (5.0) pour la transmission à celle-ci d'une variation de la capacité en fonction d'influences extérieures,
**caractérisé en ce que** le deuxième élément conducteur (1.3) est relié par l'intermédiaire d'une résistance électrique élevée à l'électronique de détection (5.0) pour la transmission à celle-ci d'une variation de la capacité en fonction d'influences extérieures, le premier élément conducteur (1.5) étant disposé entre la surface de support (1.1) et le deuxième élément conducteur (1.3) et le deuxième conducteur électrique (1.3) émettant également le signal reçu avec essentiellement le même potentiel électrique que le premier élément conducteur (1.5).

2. Procédé selon la revendication 1, **caractérisé par** la disposition du deuxième élément conducteur (1.3) couplé de manière capacitive au premier élément conducteur (1.5) entraînant activement, lequel deuxième élément (1.3) est en liaison avec le circuit de traitement de l'électronique de détection, de manière plus éloignée de la surface de support (1.1) que le premier élément conducteur (1.5).

3. Procédé selon la revendication 1 ou 2, **caractérisé en ce que** le signal de sortie produit est influencé par un comportement modifiable par des influences extérieures des éléments conducteurs (1.3, 1.5) l'un par rapport à l'autre, en particulier par un comportement des tensions au niveau des éléments conducteurs.

4. Procédé selon l'une des revendications précédentes, **caractérisé en ce que** le rapprochement d'un objet modifie la capacité du deuxième élément conducteur (1.3) par rapport à un potentiel de référence.

5. Procédé selon l'une des revendications précédentes, **caractérisé en ce que** le premier élément conducteur (1.5) est couplé à l'électronique de détection (5.0) avec une faible résistance électrique.

6. Procédé selon l'une des revendications précédentes, **caractérisé en ce que** l'électronique de détection (5.0) détecte une variation géométrique des éléments conducteurs l'un par rapport à l'autre en tant que signal de sortie supplémentaire pour la protection contre le pincement.

7. Procédé selon l'une des revendications précédentes, **caractérisé en ce qu'**une tringle (1.2, 3.2) est disposée au niveau de chacune des deux pièces au moins mobiles l'une par rapport à l'autre, les tringles étant reliées électriquement en parallèle l'une à l'autre, ou **en ce qu'**au niveau d'une pièce (3.1) au moins des deux pièces au moins mobiles l'une par rapport à l'autre, un élément conducteur (4.2) de préférence de grande surface est disposé de manière isolée en face de la pièce et est relié en parallèle au première élément conducteur (1.5).

8. Procédé selon l'une des revendications précédentes, **caractérisé en ce que** la commande de cadençage (5.8) fournit le signal de cadence au premier élément conducteur (1.5) pour l'émission, lequel signal de cadence est reçu par le deuxième élément conducteur (1.3), le signal reçu formant un signal d'entrée en étant influencé par des influences extérieures et en étant superposé avec le signal de cadence inversé et **en ce que** le signal d'entrée est décomposé de manière cadencée de telle manière que le signal décomposé de manière cadencée reste comme une valeur de réglage (5.16) pour la formation d'une valeur de comparaison, et
**en ce qu'**au moins un régleur d'amplitude (5.9, 5.10) est prévu dans le passage du signal de cadence et/ou du signal de cadence inversé et utilise la valeur de réglage (5.16) pour le réglage des valeurs d'amplitude des signaux de cadence de telle manière que les amplitudes du signal d'entrée décomposé de manière cadencée soient essentiellement de la même importance les unes que les autres, de sorte que le signal d'entrée ne contienne pas de composantes synchronisées avec la cadence.

9. Procédé selon l'une des revendications précédentes, **caractérisé en ce que** le premier élément conducteur est relié du côté de l'entrée et le deuxième élément conducteur du côté de la sortie à un diviseur de tension.

10. Protection contre le pincement pour protéger contre un pincement d'objets ou de membres (1.7) entre au moins deux pièces mobiles l'une par rapport à l'autre, à une partie (1.1, 3.1) au moins desquelles est associée au moins une tringle (1.2, 3.2) placée sur une surface de support (1.1), laquelle tringle présente au moins deux éléments conducteurs (1.3, 1.5) espacés l'un de l'autre, s'étendant dans le sens longitudinal de la tringle et disposés tous les deux dans la tringle, avec également une électronique de détection (5.0) pour la production d'un signal de sortie en fonction d'influences extérieures, au moins un premier élément conducteur (5.1) étant réalisé en tant qu'élément émetteur pour l'émission d'un signal et au moins un deuxième élément conducteur (1.3) étant réalisé en tant qu'élément récepteur par couplage capacitif avec le premier élément conducteur (1.5), le deuxième élément conducteur (1.3) est relié à l'électronique de détection (5.0) pour la transmission à celle-ci d'une variation de capacité en fonction d'influences extérieures,
**caractérisé en ce que** le deuxième élément conducteur (1.3) est relié avec une résistance électrique élevée à l'électronique de détection (5.0) pour la transmission à celle-ci d'une variation de capacité en fonction d'influences extérieures, le premier élément conducteur (1.5) étant disposé entre la surface de support (1.1) et le deuxième élément conducteur (1.3) et **en ce que** le deuxième conducteur électrique (1.3) se trouve essentiellement au même potentiel électrique que le premier élément conducteur (1.5) grâce à l'électronique de détection (5.0) et émet également en tant qu'élément émetteur le signal reçu.

11. Protection contre le pincement selon la revendication 10, **caractérisée en ce que** le deuxième élément conducteur (1.3), couplé de manière capacitive au premier élément conducteur (1.5) entraînant de manière active, en liaison avec le circuit de traitement de l'électronique de détection, est plus éloigné de la surface de support (1.1) que le premier élément conducteur (1.5).

12. Protection contre le pincement selon la revendication 10 ou 11, **caractérisée en ce que** le signal de sortie dépend d'un comportement des éléments conducteurs (1.3, 1.5) l'un par rapport à l'autre modifiable par des influences extérieures, en particulier par un comportement des tensions au niveau des éléments conducteurs.

13. Protection contre le pincement selon l'une des revendications 10 à 12, **caractérisé en ce que** le premier élément conducteur (1.5) est couplé avec une faible résistance électrique à l'électronique de détection (5.0).

14. Protection contre le pincement selon l'une des revendications 10 à 13, **caractérisée en ce que** l'électronique de détection (5.0) est conçue de telle manière qu'elle détecte la variation géométrique des éléments conducteurs l'un par rapport à l'autre en tant que signal de sortie pour la protection contre le pincement.

15. Protection contre le pincement selon l'une des revendications 10 à 14, **caractérisé en ce qu'**une tringle (1.2, 3.2) est disposée au niveau de chacune des deux pièces au moins (1.2, 3.2) mobiles l'une par rapport à l'autre, les tringles étant reliées l'une à l'autre en parallèle, ou **en ce qu'**au niveau d'au moins une partie (3.1) des deux pièces au moins mobiles l'une par rapport à l'autre, un élément conducteur (4.2) de préférence de grande surface est disposé de manière isolée en face de la partie et est relié électriquement en parallèle au premier élément conducteur (1.5) avec essentiellement le même signal.

16. Protection contre le pincement selon l'une des revendications 10 à 15, **caractérisé en ce qu'**une commande de cadençage (5.8) est prévue, fournit un signal de cadence au premier élément conducteur (1.5) et superpose un signal de cadence inversé en tant que signal électrique avec le signal reçu par le deuxième élément conducteur (1.3).

17. Protection contre le pincement selon l'une des revendications 10 à 16, **caractérisé en ce que** la tringle (1.2, 3.2) est divisée en au moins deux pièces égales de préférence disposées symétriquement l'une par rapport à l'autre et se faisant face.

18. Protection contre le pincement selon l'une des revendications 10 à 17, **caractérisée en ce que** la commande de cadençage (5.8) est incorporée dans l'électronique de détection (5.0) de telle manière que le signal de cadence est fourni au premier élément conducteur (1.5) pour l'émission et est reçu par le deuxième élément conducteur (1.3), le signal reçu étant influencé par des influences extérieures et formant en superposition avec le signal de cadence inversé un signal d'entrée et
**en ce qu'**un démodulateur de synchronisation (5.6) est prévu pour l'association de manière cadencée du signal d'entrée de telle manière qu'aux entrées d'un comparateur (5.7), le signal décomposé de manière cadencée reste en tant que valeur de réglage (5.16) pour la formation d'une valeur de comparaison et
**en ce que** lors de la production du signal de cadence et/ou du signal de cadence inversé est prévu un régleur d'amplitude (5.9, 5.10), lequel utilise la valeur de réglage (5.16) pour le réglage des valeurs d'amplitude des signaux de cadence de telle manière que les amplitudes du signal d'entrée décomposé de manière cadencée soient essentiellement égales les unes aux autres, de sorte que le signal d'entrée ne contienne pas de composantes synchronisées avec la cadence.

19. Protection contre le pincement selon l'une des revendications 10 à 18, **caractérisée en ce que** le premier élément conducteur est relié du côté de l'entrée et le deuxième élément conducteur du côté de la sortie à un diviseur de tension.
